# EUROPEAN PATENT APPLICATION

(11) **EP 4 395 487 A1**
(43) Date of publication of application: **03.07.2024**
(21) Application number: 22860473.2
(22) Date of filing: 23.08.2022
(51) Int. Cl.: H05K 9/00

(54) **BATTERY AND ELECTRONIC DEVICE**

(30) Priority: 26.08.2021 CN 202110986868
(71) Applicant: Vivo Mobile Communication Co., Ltd., Dongguan, Guangdong 523863 (CN)
(72) Inventor: WANG, Xiaoqiang, Dongguan, Guangdong 523863 (CN)
(74) Representative: Lavoix
(86) International application number: PCT/CN2022/114137
(87) International publication number: WO 2023/025127

(57) **Abstract**

This application provides a battery and an electronic device. The battery includes a battery housing, a conductive connecting member, and a first electrode plate and a second electrode plate that are wound inside the battery housing. The first electrode plate is provided with a first tab, the second electrode plate is provided with a second tab, the first tab and the second tab are both at least partially located on the outer side of the battery housing, and the second electrode plate has a target region, between the first tab and the second tab, that is not covered by the wound first electrode plate. The conductive connecting member is located outside the battery housing and insulated from an outer sidewall of the battery housing, a first vertical projection region of the conductive connecting member on the outer sidewall is at least partially located in a second vertical projection region of the target region on the outer sidewall, and the conductive connecting member has one end connected to the first tab and another end formed as an electrode connection point of the first electrode plate.

## Description

### CROSS-REFERENCE TO RELATED APPLICATIONS

This application claims priority to Chinese Patent Application No. 202110986868.3, filed in China on August 26, 2021, which is incorporated herein by reference in its entirety.

### TECHNICAL FIELD

This application relates to the field of electronic product technologies, and in particular, to a battery and an electronic device.

### BACKGROUND

With the development of wearable electronic devices, their applications are increasingly widespread. Generally, the wearable electronic devices require independent batteries for power supply, such as button batteries. Due to the design process of positive and negative electrode plates wound inside the button battery, one electrode plate is typically longer than the other electrode plate. As a result, the electrode plate of the differential part emits electromagnetic waves due to the flow of current, leading to lower reliability of other electronic components being used.

### SUMMARY

Embodiments of this application provide a battery and an electronic device, to solve the problem that electromagnetic waves generated by the electrode plate of the battery interfere with the use of other electronic components.

According to a first aspect, an embodiment of this application provides a battery, including a battery housing, a conductive connecting member, and a first electrode plate and a second electrode plate that are wound inside the battery housing. The first electrode plate is provided with a first tab, the second electrode plate is provided with a second tab, the first tab and the second tab are both at least partially located on the outer side of the battery housing, and the second electrode plate has a target region, between the first tab and the second tab, that is not covered by the wound first electrode plate. The conductive connecting member is located outside the battery housing and insulated from an outer sidewall of the battery housing, a first vertical projection region of the conductive connecting member on the outer sidewall is at least partially located in a second vertical projection region of the target region on the outer sidewall, and the conductive connecting member has one end connected to the first tab and another end formed as an electrode connection point of the first electrode plate.

According to a second aspect, an embodiment of this application further provides an electronic device. The electronic device includes a battery, where the battery includes a housing, a conductive connecting member, and a first electrode plate and a second electrode plate that are wound inside the battery housing. The first electrode plate is provided with a first tab, the second electrode plate is provided with a second tab, the first tab and the second tab are both at least partially located on the outer side of the battery housing, and the second electrode plate has a target region, between the first tab and the second tab, that is not covered by the wound first electrode plate. The conductive connecting member is located outside the battery housing and insulated from an outer sidewall of the battery housing, a first vertical projection region of the conductive connecting member on the outer sidewall is at least partially located in a second vertical projection region of the target region on the outer sidewall, and the conductive connecting member has one end connected to the first tab and another end formed as an electrode connection point of the first electrode plate.

In this embodiment of this application, the first vertical projection region of the conductive connecting member on the outer sidewall is at least partially located in the second vertical projection region of the target region on the outer sidewall, and the conductive connecting member has one end connected to the first tab and another end formed as an electrode connection point of the first electrode plate. In this way, the conductive connecting member can partially or completely cancel out the electromagnetic waves generated in the target region of the second electrode plate, reducing electromagnetic interference on other electronic components, thus improving the reliability of other electronic components being used.

For additional aspects and advantages of this application, some will be given in the following description, and some will become apparent in the following description or will be understood in the practice of this application.

### BRIEF DESCRIPTION OF DRAWINGS

The above and/or additional aspects and advantages of this application will become obvious and easy to understand from the description of the embodiments with reference to the following drawings.
FIG. 1 is a first structural diagram of a battery according to an embodiment of this application;
FIG. 2 is a second structural diagram of a battery according to an embodiment of this application; and
FIG. 3 is a third structural diagram of a battery according to an embodiment of this application.

### DETAILED DESCRIPTION OF EMBODIMENTS

The embodiments of this application are described in detail below. Examples of the embodiments are shown in the accompanying drawings, and reference signs that are the same or similar always indicate the same or similar components or components with the same or similar functions. The embodiments described below with reference to the drawings are illustrative and merely for explaining this application. They should not be construed as limitations on this application. All other embodiments obtained by persons of ordinary skill in the art based on the embodiments of this application without creative efforts shall fall within the protection scope of this application.

A feature modified by the term "first", "second", or the like in the specification and claims of this application can explicitly or implicitly include one or more such features. In the descriptions of this application, "a plurality of" means at least two unless otherwise stated. In addition, "and/or" in the specification and claims represents at least one of connected objects, and the character "/" generally indicates that the contextually associated objects have an "or" relationship.

In the description of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for the ease and brevity of description of the embodiments of this application rather than indicating or implying that the means or components mentioned must have specific orientations or must be constructed or manipulated according to specific orientations, and therefore shall not be construed as any limitations on embodiments of this application.

In the description of this application, it should be noted that unless otherwise specified and defined explicitly, the terms "mounting", "connection", and "join" should be understood in their general senses. For example, they may refer to a fixed connection, a detachable connection, or an integral connection; a mechanical connection or an electrical connection; and a direct connection, an indirect connection via an intermediate medium, or an internal communication between two elements. Persons of ordinary skill in the art can understand specific meanings of these terms in this application as appropriate to specific situations.

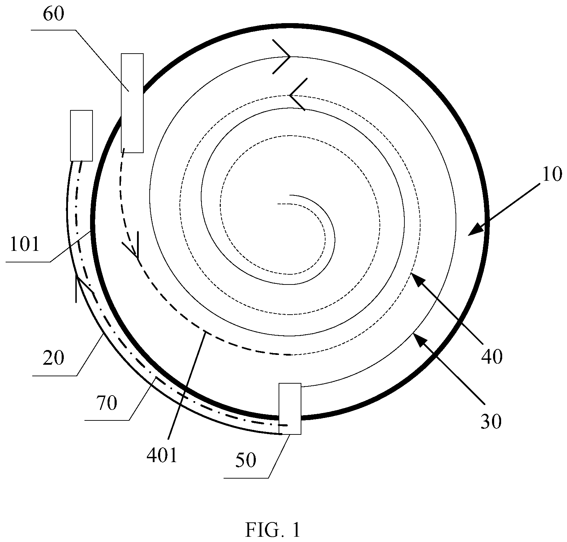

Referring to FIG. 1, FIG. 1 is a structural diagram of a battery according to an embodiment of this application. As shown in FIG. 1, a battery provided by this embodiment of this application includes a battery housing 10, a conductive connecting member 20, and a first electrode plate 30 and a second electrode plate 40 that are wound inside the battery housing 10. The first electrode plate 30 is provided with a first tab 50, the second electrode plate 40 is provided with a second tab 60, the second tab 60 and the first tab 50 are both at least partially located on the outer side of the battery housing 10, and the second electrode plate 40 has a target region 401, between the first tab 50 and the second tab 60, that is not covered by the wound first electrode plate 30. The conductive connecting member 20 is located outside the battery housing 10 and insulated from an outer sidewall 101 of the battery housing 10, a first vertical projection region of the conductive connecting member 20 on the outer sidewall 101 is at least partially located in a second vertical projection region of the target region 401 on the outer sidewall 101, and the conductive connecting member 20 has one end connected to the first tab 50 and another end formed as an electrode connection point of the first electrode plate 30.

In this embodiment of this application, the first electrode plate 30 and the second electrode plate 40 are different electrode plates. For example, if the first electrode plate 30 is a positive electrode plate, the second electrode plate 40 is a negative electrode plate. Alternatively, if the first electrode plate 30 is a negative electrode plate, the second electrode plate 40 is a positive electrode plate. To ensure that lithium ions moving from the positive electrode are received by the negative electrode and prevent lithium precipitation, the negative electrode plate may be longer than the positive electrode plate. That is, the first electrode plate 30 is the positive electrode plate, the second electrode plate 40 is the negative electrode plate, and the electrode connection point may be understood as a positive electrode connecting point. Optionally, the target region may be understood as a region, on the outer side of the second electrode plate 40, that is not covered or wrapped by the first electrode plate 30, or as a differential part between the outer side of the second electrode plate 40 and the outer side of the first electrode plate 30. For example, the target region is a region, of the outermost layer of the second electrode plate 40, that is not covered or wrapped by the first electrode plate 30.

It should be understood that in this embodiment of this application, an end of the conductive connecting member 20, formed as the positive electrode connecting point, may be understood as the positive electrode of the battery, and the second tab 60 may be understood as the negative electrode of the battery. In the process of supplying power from the battery, the first electrode plate 30 and the second electrode plate 40 have the same current path, and a direction of current in portions of the second electrode plate 40 other than the target region 401 is opposite to a direction of current in the first electrode plate 30. Therefore, electromagnetic waves (that is, a magnetic field) generated in the portions other than the target region 401 of the second electrode plate 40 is canceled out by the electromagnetic waves generated by the first electrode plate 30. In addition, opposite currents are formed in the conductive connecting member 20 and the target region of the second electrode plate 40. Therefore, the magnetic field generated in a portion of the target region of the second electrode plate 40 corresponding to the conductive connecting member 20 is canceled out by the electromagnetic waves generated by the conductive connecting member 20, reducing leakage of the electromagnetic waves from the differential part (or the target region of the second electrode plate 40) between the second electrode plate 40 and the first electrode plate 30 to reduce electromagnetic interference on other electronic components and thereby improving the reliability of other electronic components being used.

It should be noted that in FIG. 1, a dotted line 40 represents the second electrode plate and a dash-dotted line 70 represents an insulating glue layer. The dotted line, dash-dotted line, and solid line are used for only distinguishing the position relationships between different components. An arrow on the first electrode plate 30 in the figure represents a flow direction of the current in the first electrode plate 30, an arrow on the second electrode plate 40 represents a flow direction of the current in the second electrode plate 40, and the arrow on the conductive connecting member 20 represents a flow direction of the current in the conductive connecting member 20. It can be seen that the flow direction of the current in the second electrode plate 40 is opposite to the flow direction of the current in the conductive connecting member 20, and therefore the electromagnetic waves generated in the target region of the second electrode plate 40 can be canceled out by the electromagnetic waves generated by the conductive connecting member 20. It should be understood that in the charging and discharging states, currents in the electrode plates flow in different directions. The figure only shows different flow directions of the current in the first electrode plate 30 and the current in the second electrode plate 40, and does not limit their operation states.

Optionally, that the first vertical projection region of the conductive connecting member 20 on the outer sidewall 101 is at least partially located in the second vertical projection region of the target region 401 on the outer sidewall 101 can be understood as: The first vertical projection region of the conductive connecting member 20 on the outer sidewall 101 at least partially overlaps the second vertical projection region of the target region 401 on the outer sidewall 101. In addition, the wound conductive connecting member 20 covers at least part of the target region 401 of the second electrode plate 40, such that the conductive connecting member 20 partially or completely cancels out the electromagnetic waves generated in the target region 401 of the second electrode plate 40. As shown in FIG. 1, the conductive connecting member 20 is substantially parallel to the target region 401 of the second electrode plate 40, and the wound conductive connecting member 20 covers the entire target region 401 of the second electrode plate 40.

It should be noted in this embodiment of this application, the foregoing battery may be applied to the wearable electronic devices to supply power to the electronic components in the wearable electronic device. The wearable electronic device may be an electronic device such as a smart watch, a smart bracelet, Bluetooth headphones, smart 3D glasses, or the like. The foregoing other electronic components may be understood as the electronic components, other than the battery in the wearable electronic device, that are susceptible to electromagnetic wave interference. Taking Bluetooth headphones as an example, the other electronic components may include electronic components of a Bluetooth module, electronic components of an audio module, and electronic components of other modules. The other electronic components may be understood as electronic components including the audio modules. The battery may be a cylindrical battery such as a button battery.

In this embodiment of this application, the first vertical projection region of the conductive connecting member 20 on the outer sidewall 101 is at least partially located in the second vertical projection region of the target region 401 on the outer sidewall 101, and the conductive connecting member 20 has one end connected to the first tab 50 and another end formed as an electrode connection point of the first electrode plate 30. In this way, the conductive connecting member 20 can partially or completely cancel out the electromagnetic waves generated in the target region 401 of the second electrode plate 40, reducing the electromagnetic interference on other electronic components, thus improving the reliability of the other electronic components being used.

Optionally, in some embodiments, length of the first vertical projection region in a winding direction is greater than or equal to length of the second vertical projection region in the winding direction.

In the embodiments of this application, the first electrode plate 30 and the second electrode plate 40 may be wound clockwise or anticlockwise. That the length of the first vertical projection region in a winding direction is greater than or equal to the length of the second vertical projection region in the winding direction may be understood as: length of an entity formed by the first electrode plate 30, the first tab 50, and the conductive connecting member 20 in the winding direction is greater than or equal to the length of the second electrode plate 40 in the winding direction. In this way, the conductive connecting member 20 can completely cancel out the electromagnetic waves generated in the target region 401 of the second electrode plate 40.

It should be noted that the length and structure of the conductive connecting member 20 may be designed based on the length of the target region of the second electrode plate 40, which is described in detail using some specific examples below.

Optionally, in some embodiments, the conductive connecting member 20 includes a first connecting portion 201, a second connecting portion 202, and a third connecting portion 203. The first connecting portion 201 has one end connected to the first tab 50 and another end connected to the third connecting portion 203 via the second connecting portion 202.

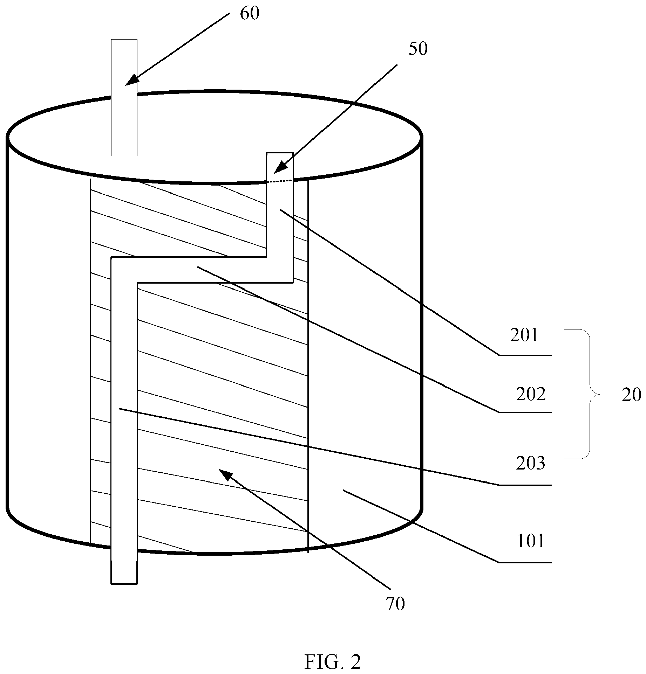

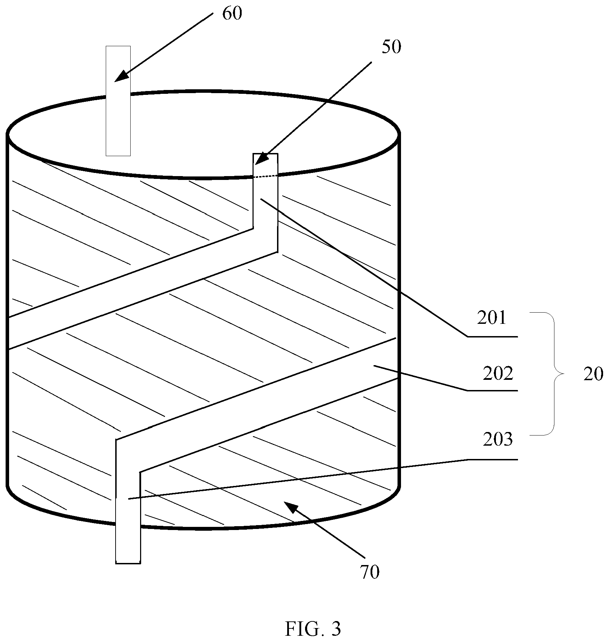

In the embodiments of this application, as shown in FIG. 2 and FIG. 3, the first connecting portion 201 is apart from and parallel to the third connecting portion 203. The second connecting portion 202 may be disposed circumferentially, and as shown in FIG. 2, the second connecting portion 202 is parallel to end surfaces of the upper end and the lower end of the battery housing 10.

Optionally, in some embodiments, vertical projections of the first connecting portion 201, second connecting portion 202, and third connecting portion 203 on the outer sidewall 101 are all located in the second vertical projection region, and length of the first vertical projection region in a winding direction is greater than length of the second vertical projection region in the winding direction.

In the embodiments of this application, the target region 401 is wound at a circumferential angle smaller than 360°. In this way, the electromagnetic waves generated by current conducted through the conductive connecting member 20 completely cancel out the electromagnetic waves generated in the target region 401 of the second electrode plate 40 while avoiding generation of new electromagnetic waves by the conductive connecting member 20.

Optionally, in some embodiments, specifically, as shown in FIG. 3, the target region 401 is wound at a circumferential angle greater than or equal to 360°, the first connecting portion 201 and the third connecting portion 203 are respectively close to two opposite ends of the battery housing 10, and the second connecting portion 202 spirally surrounds the outer sidewall 101 by at least one circle.

In the embodiments of this application, that the first connecting portion 201 and the third connecting portion 203 are respectively close to two opposite ends of the battery housing 10 can be understood as that the first connecting portion 201 and the third connecting portion 203 are respectively disposed at two opposite ends of the battery housing 10. For example, the first connecting portion 201 is disposed at a first end of the battery housing 10, and a distance from a geometric center of the first connecting portion 201 to the second end of the battery housing 10 is greater than or far greater than a distance from this center to the first end of the battery housing 10. The third connecting portion 203 is disposed at a second end of the battery housing 10, and a geometric center of the third connecting portion 203 to the first end of the battery housing 10 is greater than or far greater than a distance from this center to the second end of the battery housing 10. Because the second connecting portion 202 spirally surrounds the outer sidewall 101 by at least one circle, the electromagnetic waves generated in the target region 401 of the second electrode plate 40 can be canceled out to the maximum extent, thus preventing the electromagnetic waves generated in the target region 401 of the second electrode plate 40 from being leaked out to cause electromagnetic interference on other components.

Optionally, an insulating glue layer 70 is provided between the conductive connecting member 20 and the outer sidewall 101, and the conductive connecting member 20 is bonded and fixed to the outer sidewall 101 via the insulating glue layer 70.

In the embodiments of this application, the forgoing insulating glue layer can be made of a double-sided adhesive or another isolating fixing material. As the insulating glue layer is used for bonding and fixing, insulation is ensured while the conductive connecting member 20 is fixed to the outer sidewall 101. This results in a simple process that is conducive to industrial production.

It should be understood that the material of the battery housing 10 may be chosen based on actual requirements. For example, in some embodiments, the battery housing 10 is made of a battery aluminum-plastic film.

It should be noted that the structure of the foregoing conductive connecting member 20 may be adjusted based on actual requirements. For example, in some embodiments, the conductive connecting member 20 and the first tab 50 are formed integrally.

In the embodiments of this application, it can be understood that the first tab 50 is formed by a relatively long conductive member, and after the wound first electrode plate 30 and second electrode plate 40 are packaged with the battery housing 10, the first tab 50 can be bent to obtain the structure of the conductive connecting member 20. As the conductive connecting member 20 and the first tab 50 are formed integrally, the first tab 50 only needs to be bent and bonded and fixed outside the battery housing 10 via the insulating glue layer 70. This results in a simple structure that is conducive to industrial production and application.

Further, an embodiment of this application provides an electronic device. The electronic device includes a battery, and the structure of the battery can refer to the foregoing embodiments. Because the structure of the battery in the foregoing embodiments is used in this embodiment of this application, the electronic device provided in this embodiment of this application has all the beneficial effects of the battery described in the foregoing embodiments. Specific details can be referred to the description of the foregoing embodiments, and are not repeated here.

In the description of this specification, descriptions referring to the terms "an embodiment", "some embodiments", "exemplary embodiments", "an example", "a specific example", or "some examples" mean the specific features, structures, materials or characteristics described with to the embodiment or example are included in at least one embodiment or example of this application. In this specification, illustrative expressions of these terms do not necessarily refer to the same embodiment or example. Moreover, the specific features, structures, materials, or characteristics described may be combined in any suitable manners in any one or more embodiments or examples.

Although some embodiments of this application have been illustrated and described, those of ordinary skill in the art can understand that various changes, modifications, substitutions, and variations of these embodiments may be made without departing from the principle and purpose of this application, and the scope of this application is defined by the claims and their equivalents.

## Claims

1. A battery, comprising a battery housing, a conductive connecting member, and a first electrode plate and a second electrode plate that are wound inside the battery housing, wherein the first electrode plate is provided with a first tab, the second electrode plate is provided with a second tab, the first tab and the second tab are both at least partially located on the outer side the battery housing, and the second electrode plate has a target region, between the first tab and the second tab, that is not covered by the wound first electrode plate; and the conductive connecting member is located outside the battery housing and insulated from an outer sidewall of the battery housing, a first vertical projection region of the conductive connecting member on the outer sidewall is at least partially located in a second vertical projection region of the target region on the outer sidewall, and the conductive connecting member has one end connected to the first tab and another end formed as an electrode connection point of the first electrode plate.

2. The battery according to claim 1, wherein length of the first vertical projection region in a winding direction is greater than or equal to length of the second vertical projection region in the winding direction.

3. The battery according to claim 1, wherein the conductive connecting member comprises a first connecting portion, a second connecting portion, and a third connecting portion, wherein the first connecting portion has one end connected to the first tab and another end connected to the third connecting portion via the second connecting portion.

4. The battery according to claim 3, wherein vertical projections of the first connecting portion, the second connecting portion, and the third connecting portion on the outer sidewall are all located in the second vertical projection region, and length of the first vertical projection region in the winding direction is equal to length of the second vertical projection region in the winding direction.

5. The battery according to claim 3, wherein when the target region is wound at a circumferential angle greater than or equal to 360°, the first connecting portion and the third connecting portion are respectively disposed close to two opposite ends of the battery housing, and the second connecting portion spirally surrounds the outer sidewall by at least one circle.

6. The battery according to any one of claims 1 to 5, wherein an insulating glue layer is provided between the conductive connecting member and the outer sidewall, and the conductive connecting member is bonded and fixed to the outer sidewall via the insulating glue layer.

7. The battery according to any one of claims 1 to 5, wherein the first electrode plate is a positive electrode plate and the second electrode plate is a negative electrode plate.

8. The battery according to any one of claims 1 to 5, wherein the battery housing is a battery aluminum-plastic film.

9. The battery according to any one of claims 1 to 5, wherein the conductive connecting member and the first tab are integrally formed.

10. An electronic device, comprising the battery according to any one of claims 1 to 9.
